# EUROPÄISCHE PATENTSCHRIFT

(11) **EP 4 221 927 B1**
(45) Veröffentlichungstag und Bekanntmachung des Hinweises auf die Patenterteilung: **29.01.2025**
(21) Anmeldenummer: 21786126.9
(22) Anmeldetag: 28.09.2021
(51) Int. Cl.: B23K 1/00, B23K 1/20, B23K 20/16, F16B 31/02, G01L 5/24, B23K 101/20

(54) **VERFAHREN ZUR HERSTELLUNG VON LASTENANZEIGENDEN VERBINDUNGSBAUTEILEN UND ENTSPRECHENDES LASTANZEIGENDES VERBINDUNGSBAUTEIL**
METHOD FOR PRODUCING LOAD-INDICATING CONNECTION COMPONENTS, AND CORRESPONDING LOAD-INDICATING CONNECTION COMPONENT
PROCÉDÉ DE PRODUCTION DE COMPOSANTS DE LIAISON INDICATEURS DE CHARGE, ET COMPOSANT DE LIAISON INDICATEUR DE CHARGE

(30) Priorität: 01.10.2020 DE 102020125707
(43) Veröffentlichungstag der Anmeldung: 09.08.2023
(73) Patentinhaber: Intellifast GmbH, 67346 Speyer (DE)
(72) Erfinder: HÖRING, Gert, 76815 Karlsruhe (DE)
(74) Vertreter: Paustian, Othmar
(86) Internationale Anmeldenummer: PCT/EP2021/076590
(87) Internationale Veröffentlichungsnummer: WO 2022/069443

(56) Entgegenhaltungen:
- EP-A2- 2 010 883
- EP-B1- 2 010 883
- CN-A- 111 504 542
- DE-A1- 102013 109 879
- US-A1- 2017 010 167

## Beschreibung

Die Erfindung betrifft ein Verfahren zur Herstellung von lastanzeigenden Verbindungsbauteilen und ein lastanzeigendes Verbindungsbauteil entsprechend dem Oberbegriff der Ansprüche 1 und 10 (siehe z.B. CN 111 504 542 A).

### Stand der Technik

Mechanische Verbindungsbauteile, wie z. B. Schrauben oder Bolzen, werden auf einfache Weise mittels Ultraschall-Messverfahren auf ihre Vorspannkraft hin überprüft. Dazu wird die Signallaufzeit von Ultraschallwellen, die in das Verbindungsbauteil ein- und als Echosignal wieder ausgekoppelt werden, gemessen. Bei den zur Anregung verwendeten Ultraschallpulsen kann es sich sowohl um Signale mit fester Frequenz als auch um Signale, die sich aus verschiedenen Frequenzanteilen zusammensetzen, handeln. Im Zuge der fortschreitenden Materialwissenschaften sind in den letzten Jahren eine Vielzahl von Verbund- und gradierten Werkstoffen sowie Speziallegierungen eingeführt worden, aus denen Verbindungsbauteile, wie Bolzen oder Schrauben, gefertigt werden können, deren Materialeigenschaften höhere Anforderungen an ein Messverfahren zur Bestimmung der Vorspannkraft stellen.

Für eine zuverlässige Messung der Signallaufzeit der Ultraschallwellen in dem Bauteil ist eine gute Kopplung zwischen dem Ultraschallwandler und dem Verbindungsbauteil erforderlich. Werden beispielsweise ein Ultraschallwandler und das Verbindungsbauteil miteinander verklebt, wirkt sich der Zustand der Klebeschicht auf die Qualität der Messung aus. Der Zustand der Klebeschicht kann dabei insbesondere stark von einer aktuellen Temperatur abhängig sein und kann sich insbesondere auch durch eine Alterung der Klebeschicht mit der Zeit verändern. Des Weiteren sind übliche Klebeschichten nur begrenzt gegen chemische Einflüsse aus der Umgebung resistent. Insbesondere bei Einsatz der lastanzeigenden Verbindungsbauteile in Offshore-Windkraftanlagen ist hier problematisch, dass übliche Klebstoffe oftmals nicht beständig gegenüber der salzhaltigen Seeluft sind.

Aus EP 2010883 ist ein Verbindungsbauteil mit einem temperaturfesten Sensorelement bekannt, bei dem ein piezoelektrischer Ultraschallwandler über ein Sputterverfahren auf das Verbindungselement aufgebracht wird. Hierdurch werden Klebeschichten zur Verbindung des Verbindungsbauteils und des piezoelektrischen Ultraschallwandlers vermieden.

Nachteilig hieran ist jedoch, dass derartige Aufdampfverfahren aufwändig sind. Sowohl die Investitionen für die Anschaffung der benötigten Vakuumkomponenten als auch die Kosten für deren Betrieb und Unterhaltung sind relativ hoch. Insbesondere aufgrund des beschränkten Volumens in den Aufdampfanlagen sinkt der Durchsatz bei der Produktion der lastanzeigenden Verbindungsbauteile exponentiell mit zunehmender Größe des Verbindungsbauteils. In der gleichen Weise steigen die Stückkosten mit zunehmender Verbindungsbauteilgröße. Kostengünstig lassen sich in der Regel in Vakuumanlagen nur lastanzeigende Verbindungsbauteile bis zu einem maximalen Nenndurchmesser von M20 beschichten. Für Großschrauben, wie sie zum Beispiel zunehmend im Windkraftbereich Anwendung finden, muss der Endkunde erhöhte Kosten für die Instrumentierung der Verbindungselemente mit Ultraschallsensoren in Kauf nehmen.

Aus WO 2010/085942 A2 ist ein Mikrosystem bekannt, das aus zwei Verbindungssubstraten und einer zwischen den Verbindungssubstraten liegenden Struktur besteht. Die Struktur umfasst ein reagiertes reaktives Schichtsystem. In einer Ausführungsform ist das Mikrosystem ein Sensor, der eine piezoelektrische Komponente aufweist. Zum Verbinden der Verbindungssubstrate wird ein reaktives Mehrschichtsystem verwendet. Das reaktive Mehrschichtsystem umfasst mindestens eine Oberflächenschicht mit vertikal ausgerichteten, im Abstand voneinander angeordneten Nanostrukturen und Bereichen zwischen den Nanostrukturen, die mit einem Material gefüllt sind, das ein Reaktionspartner für das Material der Nanostrukturen ist.

Aus EP 0 915 524 A1 ist eine piezoelektrische Vorrichtung mit einem schwingfähigen Element bekannt, welches mindestens zwei Elemente aufweist, welche Biegeschwingungen ausführen können. Jedes der Elemente trägt ein piezoelektrisches Antriebselement und mindestens eines der Elemente trägt ein piezoelektrisches Ausgangselement. Die Antriebselemente werden durch eine Spannung angeregt, welche eine Quer- oder Längsverformung des piezoelektrischen Antriebselements verursacht. Die Schwingung wiederum induziert eine Biegeschwingung der Elemente. Das Ausgangselement weist ebenfalls ein piezoelektrisches Element auf und weist Elektroden zum Abgreifen einer elektrischen Spannung auf. Die Vorrichtung kann beispielsweise als ein Filter oder als ein Transformator eingesetzt werden. Zum Verbinden der piezoelektrischen Elemente mit dem schwingfähigen Element kann ein reaktiver Metalldünnfilm verwendet werden.

Aus WO 2010/096439 A1 ist ein Resonanzsensor bekannt, der als aktives Element ein zweilagiges System aus einer aktiven piezoelektrischen Schicht und einer passiven Schicht umfasst, die miteinander gekoppelt sind. Zum Herstellen des zweilagigen Systems wird ein Wafer aus dem piezoelektrischen Material beidseitig metallisiert. Als passive Schicht wird ein Wafer aus Aluminiumoxid ebenfalls mit einer Metallisierung versehen und konventionell oder reaktiv mit der aktiven Schicht verlötet.

Eine Aufgabe der Erfindung kann darin gesehen werden, ein Verfahren zur Herstellung eines zuverlässigen und gegen Temperatur und chemische Einflüsse resistenten lastanzeigenden Bauteils bereitzustellen, welches einfach auszuführen ist und einen großen Durchsatz ermöglicht.

### Offenbarung der Erfindung

Ein Verfahren zur Herstellung von lastanzeigenden Verbindungsbauteilen entsprechend der Erfindung ist im Anspruch 1 definiert.

Nach dem Ausreagieren der reaktiven Schicht ist der Ultraschallwandler fest mit dem Verbindungselement verlötet. Das Pressen wird beendet und das fertige lastanzeigende Verbindungsbauteil kann aus einer entsprechenden Vorrichtung zum Aufbringen des Pressdrucks entnommen werden.

Entsprechend der Erfindung sind eine erste und eine zweite Lotschicht bei der Schichtstruktur eingesetzt, um ein optimales Verlöten des Ultraschallwandlers mit dem Verbindungselement zu ermöglichen.

Durch das Aktivieren der reaktiven Schicht entsteht Wärme. Diese Wärme bringt die erste Lotschicht und die zweite Lotschicht zumindest teilweise zum Schmelzen und ermöglicht somit eine Verbindung zwischen dem dann ausreagierten System der reaktiven Schicht und den Lotschichten und damit zwischen den Oberflächen des Verbindungselements und des Ultraschallwandlers.

Das Aktivieren der reaktiven Schicht kann beispielsweise durch Erwärmen mit einem Laserstrahl erfolgen, der auf eine Oberfläche der reaktiven Schicht fokussiert wird. Alternativ hierzu kann die reaktive Schicht beispielsweise mit einer Elektrode kontaktiert werden, und ein elektrischer Strom zur kurzzeitigen lokalen Erwärmung der reaktiven Schicht kann eingeleitet werden. Das Verbindungselement dient hierbei als zweite Elektrode.

Entsprechend der Erfindung ist das Verbindungselement eine Schraube und ist die Oberfläche des Verbindungselements eine Oberfläche des Schraubenkopfs der Schraube oder eine Oberfläche an dem Schraubenkopf entgegengesetzten Ende der Schraube. Das Verfahren ist dabei grundsätzlich für Schrauben jeglicher Größe und Form geeignet, wobei die Vorteile des Verfahrens insbesondere bei größeren Schrauben ab einer Größe von M20 besonders hervortreten.

Entsprechend der Erfindung ist die Schraube aus Stahl, Edelstahl, hochlegierten Stählen, Sonderstählen, Titan und dessen Legierungen, TiAl6V4, Aluminium und dessen Legierungen, Nickellegierungen (Inconel), amagnetischen Stählen, wie A286, Messing oder Kupfer und dessen Legierungen gefertigt.

Der piezoelektrische Ultraschallwandler umfasst bevorzugt ein piezoelektrisches Element, welches eingerichtet ist, bei Anregung mit einem entsprechenden elektrischen Signal Schwingungen im Ultraschall zu erzeugen. Für das Eingeben eines elektrischen Signals umfasst der piezoelektrische Ultraschallwandler bevorzugt auf einer Oberfläche eine Elektrode, welche beispielsweise als eine aufgedruckte oder mit einem Aufdampfverfahren beschichtete Elektrode ausgestaltet sein kann. Diese mit der Elektrode versehene Oberfläche ist bei der Bildung der Schichtstruktur von der Oberfläche des Verbindungselements abgewandt, so dass die Elektrode zugänglich ist.

Insbesondere kann es sich bei der Elektrode um eine mittels Aufdrucken hergestellte Dickschichtelektrode mit einer Dicke im Bereich von beispielsweise 5 µm bis 10 µm handeln. Dabei wird beispielsweise mit einem Siebdruckverfahren eine silberhaltige Paste aufgedruckt. Alternativ kann es sich bei der Elektrode insbesondere um eine Dünnschichtelektrode mit einer typischen Dicke von ca. 1 µm handeln, welche beispielsweise durch Aufsputtern von Nickelchrom, Gold oder Silber erhalten werden kann.

Als Gegenelektrode dient in dem hergestellten lastanzeigenden Verbindungsbauteil bevorzugt die Oberfläche des Verbindungselements. Vorteilhafterweise wird durch die ausreagierte reaktive Schicht sowie die gegebenenfalls vorhandenen Lotschichten eine gute elektrische Verbindung zu der dem Verbindungsbauteil zugewandten Seite des Ultraschallwandlers hergestellt.

Das piezoelektrische Element ist bevorzugt aus einer piezoelektrischen Keramik wie Blei-Zirkonat-Titanat (PZT) hergestellt.

Die piezoelektrische Keramik kann beispielsweise in Form einer Scheibe bereitgestellt werden. Die Scheibe kann beispielsweise einen Durchmesser im Bereich von 1 mm bis 10 mm, bevorzugt im Bereich von 2 mm bis 5 mm aufweisen. Typische Dicken liegen im Bereich von 0,1 mm bis 0,75 mm, bevorzugt im Bereich von 0,25 mm bis 0,5 mm. Neben der Scheibenform können auch piezoelektrische Keramiken mit quadratischer oder rechteckiger Grundfläche mit Kantenlängen von 1 bis 10 mm, bevorzugt im Bereich von 2 mm bis 5 mm, bereitgestellt werden. Typische Dicken liegen auch hier im Bereich von 0,1 mm bis 0,75 mm, bevorzugt im Bereich von 0,25 mm bis 0,5 mm.

In einer Ausführungsform des Verfahrens wird die Schichtstruktur gebildet durch Aufbringen der ersten Lotschicht auf die Oberfläche des Verbindungselements und Aufbringen der zweiten Lotschicht auf den Ultraschallwandler, Zuschneiden einer reaktiven Bondfolie, welche die reaktive Schicht umfasst, Auflegen der reaktiven Bondfolie auf die erste Lotschicht auf dem Verbindungselement und Auflegen des Ultraschallwandlers auf die Bondfolie, wobei die zweite Lotschicht in Richtung der Bondfolie weist.

In dieser Variante des Verfahrens wird neben der ersten Lotschicht auf der Oberfläche des Verbindungselements eine zweite Lotschicht verwendet, welche auf der der Bondfolie zugewandten Seite des piezoelektrischen Ultraschallwandlers aufgebracht wird. Die Lotschichten können beispielsweise durch Aufbringen geschmolzenen Lots oder durch ein Aufdampfverfahren aufgebracht werden. Dabei kann die erste und/oder die zweite Lotschicht gegebenenfalls entfallen, sofern die entsprechende Oberfläche des Verbindungselements beziehungsweise des Ultraschallwandlers für ein direktes Löten geeignet ist.

In einer Variante des Verfahrens wird eine Bondfolie verwendet, die neben der reaktiven Schichtstruktur sowohl auf der Ober- als auch auf der Unterseite bereits belotet ist und somit die erste und die zweite Lotschicht umfasst. Damit kann das Aufbringen einer ersten Lotschicht auf das Verbindungselement und einer zweiten Lotschicht auf den Ultraschallwandler entfallen. Diese Variante des Verfahrens setzt voraus, dass sich die jeweils der Bondfolie zugewandten Seiten des Verbindungselements und des Ultraschallwandler beloten lassen. Das heißt, dass in diesem Fall keine zusätzlichen Schichten, wie eine haftvermittelnde Zwischenschicht für eine Verbindung mit der entsprechenden Oberfläche des Verbindungselements bzw. des Ultraschallwandlers, erforderlich sind.

Bevorzugt wird die Bondfolie derart zugeschnitten, dass die Form der Bondfolie der Form des Ultraschallwandlers entspricht. In diesem Fall erfolgt eine Aktivierung der reaktiven Schicht bevorzugt durch Einbringen der erforderlichen Aktivierungsenergie von der Seite der reaktiven Schicht.

Alternativ hierzu ist es bevorzugt, die Bondfolie derart zuzuschneiden, dass ein Teil der Bondfolie nach dem Auflegen des piezoelektrischen Ultraschallwandlers nicht durch den Ultraschallwandler überdeckt ist. Beispielweise kann hierzu die Form der Bondfolie generell größer gewählt werden oder eine Art Lasche aufweisen, welche nicht von dem Ultraschallwandler überdeckt wird. Eine Aktivierung der reaktiven Schicht kann in diesem Fall von der Oberseite der Bondfolie erfolgen.

Das Zuschneiden der Bondfolie kann mechanisch, beispielsweise unter Verwendung eines Rollmessers, erfolgen. Besonders bevorzugt erfolgt das Zuschneiden der reaktiven Bondfolie mittels Laserschneiden. Dabei wird bevorzugt ein Kurzpulslaser, insbesondere ein Ultrakurzpulslaser (UKP-Laser) verwendet, um die Bondfolie zu schneiden, ohne dass das reaktive System der Bondfolie aktiviert wird. Die Pulsdauer der Laserpulse liegt dabei im Pikosekunden- (ps) oder Femtosekunden- (fs) Bereich.

In einer Ausführungsform des Verfahrens wird die Schichtstruktur durch Beschichten einer Oberfläche des Ultraschallwandlers mit einer zweiten Lotschicht und dem reaktiven Schichtsystem gebildet. Anschließend erfolgt das Auflegen des beschichteten Ultraschallwandlers auf die Oberfläche des Verbindungselements, wobei die reaktive Schicht der Oberfläche des Verbindungselements zugewandt ist. Die Oberfläche des Verbindungselements wird dabei zuvor mit der ersten Lotschicht versehen. Sofern die Oberfläche des Ultraschallwandlers direkt lötfähig ist, kann die zweite Lotschicht entfallen. Ist eine erste Lotschicht erforderlich, kann diese auf die Oberfläche des Verbindungselements aufgebracht werden.

Bevorzugt bestehen die erste Lotschicht und/oder die zweite Lotschicht aus einem Metall, wie z. B. Gold, Silber, Zinn und Zink oder einer Metalllegierung. Eine geeignete Metallschicht ist beispielsweise eine Zinnschicht. Die erste und/oder die zweite Lotschicht kann insbesondere als Folie, Formteil, Puder oder Paste auf die entsprechende Oberfläche aufgetragen oder durch Galvanisieren oder durch ein Aufdampfverfahren aufgebracht werden.

Alternativ dazu bestehen die erste Lotschicht und/oder die zweite Lotschicht bevorzugt aus einem sogenannten Aktivlot. Aktivlote sind metallische Lote, welche aufgrund ihrer Legierungszusammensetzung in der Lage sind, neben metallischen Oberflächen auch nichtmetallische anorganische Werkstoffe zu benetzen. Derartige Aktivlote beinhalten als Lotwerkstoff Komponenten aus Silber, Nickel, Kupfer und Gold und sogenannte Aktiv-Elemente, wie Titan, Hafnium, Zirkonium oder Vanadium, die den Lötprozess erst ermöglichen. Geeignete Aktivlote sind zum Beispiel unter dem Namen Incusil^{®} erhältlich. Incusil^{®} ABA beispielsweise ist eine Legierung aus Silber, Kupfer, Indium und Titan und für direktes Anwenden auf keramischen Oberflächen geeignet. Das Aktivlot kann insbesondere als Folie, Formteil, Puder oder Paste auf die entsprechende Oberfläche aufgetragen oder durch Galvanisieren oder durch ein Aufdampfverfahren aufgebracht werden.

Entsprechend der Erfindung bestehen die erste Lotschicht und/oder die zweite Lotschicht bevorzugt aus einem Schichtsystem, welches mindestens eine haftverbessernde Zwischenschicht und eine Lage eines Lotmaterials als Hauptschicht umfasst.

Als haftverbessernde Zwischenschicht sind insbesondere Schichten, bestehend aus Titan, Chrom oder Nickelchrom geeignet. Eine Hauptschicht des Schichtsystems umfasst das eigentliche Lotmaterial, wie z. B. Gold, Silber, Zinn und Zink.

Bevorzugt wird die mindestens eine haftverbessernde Zwischenschicht erhalten durch Beschichten der Oberfläche des Verbindungselements, einer Oberfläche der reaktiven Schicht oder einer Oberfläche des piezoelektrischen Ultraschallwandlers. Die weitere Schicht mit dem Lot kann entsprechend erhalten werden, indem die jeweils freie Oberfläche der Zwischenschicht mit dem Lotmaterial beschichtet wird.

Eine Gesamtdicke der ersten Lotschicht, sofern vorhanden, und/oder, sofern vorhanden, der zweiten Lotschicht, liegt bevorzugt in einem Bereich von 10 µm bis 200 µm, besonders bevorzugt im Bereich von 20 bis 100µm und beträgt beispielsweise 30 µm.

Beispielsweise können die Lotschichten als 30 µm dicke Zinnschicht ausgestaltet sein.

Wird die erste und/oder die zweite Lotschicht als ein Schichtsystem ausgestaltet, so wird die Dicke der haftverbessernden Zwischenschicht bevorzugt im Bereich von 10 nm bis 1 µm gewählt und die Dicke der Hauptschicht, welche das Lotmaterial umfasst, wird bevorzugt im Bereich von 20 µm bis 100 µm gewählt.

Für das Herstellen einer stabilen Verbindung zwischen dem Ultraschallwandler und dem Verbindungselement ist vorgesehen, den Ultraschallwandler zumindest während des Verbindungsvorgangs mit einem definierten Anpressdruck gegen das Verbindungselement zu drücken. Dadurch wird erreicht, dass beim Aufschmelzen der Lotschicht(en) eine vollflächige und definierte Verbindung hergestellt wird. Der vorgegebene Anpressdruck wird bevorzugt im Bereich von 0,3 MPa bis 3 MPa vorgegeben und beträgt beispielsweise 100 psi (ca. 0,69 MPa).

Des Weiteren kann vorgesehen sein, den Verbindungsvorgang in einer Schutzgasatmosphäre oder in einem Vakuum auszuführen. Für das Ausführen des Verbindungsvorgangs in einem Vakuum kann das Verbindungselement mit der darauf gebildeten Schichtstruktur in einen Rezipienten eingeführt werden, die Luft evakuiert werden und anschließend durch Aktivieren der reaktiven Schicht der Verbindungsvorgang gestartet werden. Während dieses Vorgangs wird beispielsweise durch eine ebenfalls in den Rezipienten eingebrachte Anpressvorrichtung der vorgegebene Anpressdruck ausgeübt. Nach dem Erkalten ist der Verbindungsvorgang beendet und das erhaltene lastanzeigende Verbindungsbauteil kann entnommen werden.

Für das Ausführen des Verbindungsvorgangs in einer Schutzgasatmosphäre kann dieser Vorgang analog zu der Ausführung in einem Vakuum in einer entsprechenden Kammer ausgeführt werden. Alternativ dazu kann auch vorgesehen sein, lediglich die Umgebungsluft durch Anströmen des gebildeten Schichtsystems lokal zu verdrängen. Als Schutzgas ist z.B. Argon geeignet.

Durch das Ausführen des Verbindungsvorgangs in einer Schutzgasatmosphäre oder in einem Vakuum kann die Qualität der entstehenden Lötverbindung gesteigert werden, da insbesondere eine Oxidbildung unter Beteiligung des Luftsauerstoffs unterdrückt wird.

Bevorzugt umfasst die reaktive Schicht bzw. das reaktive Schichtsystem ein System alternierender Schichten, wobei die alternierenden Schichten ausgewählt sind aus Ni/Al, Al/Pd, Al/Ti, Ti/Ni und Kombinationen dieser alternierenden Schichten.

Bevorzugt erfolgt ein Beschichten zur Herstellung der Lotschichten, der reaktiven Schicht und/oder der mindestens einen Zwischenschicht unter Verwendung eines Aufdampfverfahrens, insbesondere unter Verwendung eines physical vapor deposition (PVD) Verfahrens oder chemical vapor depositon (CVD) Verfahrens.

Ein bevorzugtes PVD-Verfahren ist das Sputtern, bei dem in einer Vakuumkammer durch Ionenbeschuss Atome aus einem Sputtertarget herausgelöst werden, welche sich anschließend auf dem zu beschichtenden Substrat niederschlagen.

Ein Herstellen der reaktiven Schicht kann beispielsweise erfolgen, indem ein Substrathalter bereitgestellt wird und eine Anzahl von piezoelektrischen Keramiksensoren auf den Substrathalter gelegt wird. Anschließend erfolgt ein Aufdampfen einer reaktiven Schicht, welche eine Vielzahl von einzelnen Schichten umfasst, auf das piezoelektrische Material. Die Vielzahl von einzelnen Schichten bildet ein reaktives Schichtsystem aus.

Bevorzugt weist die reaktive Schicht bzw. das reaktive Schichtsystem eine Gesamtdicke im Bereich von 10 µm bis 100 µm auf. Die Dicke der reaktiven Schicht wird entsprechend den Eigenschaften der Lotschichten sowie bevorzugt in Abhängigkeit der Dicke des eingesetzten piezoelektrischen Ultraschallwandlers und des eingestellten Anpressdrucks derart gewählt, dass einerseits genügend Energie beim Aktivieren der reaktiven Schicht für das Zustandekommen einer sicheren Verbindung zur Verfügung gestellt wird und andererseits der piezoelektrische Ultraschallwandler durch die kurzzeitig frei werdende thermische Energie mechanisch nicht beschädigt wird.

Entsprechend wird die Dicke der reaktiven Schicht bzw. des reaktiven Schichtsystems abhängig von der nach Aktivierung freigesetzten Wärmemenge gewählt. Die freigesetzte Wärmemenge wird bevorzugt so bemessen, dass die erste Lotschicht und, sofern vorhanden, die zweite Lotschicht zumindest teilweise aufgeschmolzen wird.

Geeignete reaktive Schichten sind in Form von Bondfolien unter der Bezeichnung NanoFoil^{®} von der Firma Indium Corporation erhältlich. Diese reaktiven Schichtsysteme bestehen aus alternierenden Schichten von Nickel und Aluminium und sind mit Gesamtdicken im Bereich von 40 µm bis 80 µm erhältlich. Die maximale Temperatur während der Reaktion liegt im Bereich von 1350°C bis 1500°C, wobei die freigesetzte Wärmemenge im Bereich von 1050 bis 1250 J/g liegt. Nach dem Aktivieren des reaktiven Schichtsystems weist das ausreagierte System eine Zusammensetzung von Ni₅₀Al₅₀ auf.

Bevorzugt ist die Oberfläche des Verbindungselements verzinkt, insbesondere feuerverzinkt. Die Verzinkung dient in dieser Konfiguration als erste Lotschicht.

Bevorzugt ist die Oberfläche des Verbindungselements so ausgestaltet, dass sich keine Prägungen und Markierungen in dem Bereich des Schraubenkopfes befinden, auf den der Ultraschallwandler aufgebracht werden soll. Weiter bevorzugt ist die entsprechende Fläche eben, was das direkte Aufbringen des Ultraschallwandlers ohne vorherige mechanische Bearbeitung des Schraubenkopfes ermöglicht.

Die Erfindung betrifft ferner ein lastanzeigendes Verbindungsbauteil entsprechend Anspruch 10.

Zwischen der Oberfläche des Verbindungselements und der reagierten reaktiven Schicht sind Teile einer ersten Lotschicht angeordnet sein, welche sich durch die Reaktionswärme der reaktiven Schicht mit der Oberfläche des Verbindungselements verbunden hat und teilweise mit der reaktiven Schicht verschmolzen ist. Zwischen der reagierten reaktiven Schicht und dem Ultraschallwandler befinden sich Teile der zweiten Lotschicht, welche teilweise mit der reagierten reaktiven Schicht verschmolzen sind.

### Vorteile der Erfindung

Das konventionelle Kleben von piezoelektrischen Keramiksensoren, wie z. B. von Blei-Zirkonat-Titanat-Scheiben (PZT), bringt verschiedene Nachteile mit sich. Neben der starken Temperaturabhängigkeit und dem Altern der Klebeschicht, der mangelnden Resistenz dieser gegenüber chemischen Umwelteinflüssen werden außerdem erhöhte Anforderungen bezüglich Rauheit und Ebenheit an die Oberfläche des Verbindungselements, auf die das piezoelektrische Element geklebt werden soll, gestellt. In der Regel müssen Verbindungselemente partiell mechanisch bearbeitet werden, vorzugsweise gefräst, bevor das piezoelektrische Element appliziert werden kann. Des Weiteren erfordert ein Verbinden durch Kleben das Einhalten von Trocknungs- bzw. Aushärtzeiten, bis die Klebeverbindung stabil und belastbar ist.

Erfindungsgemäß werden diese Nachteile durch das Verwenden eines Lötprozesses überwunden. Durch den Lötprozess können Unzulänglichkeiten in den Oberflächen der zu verbindenden Bauteile ausgeglichen werden, da das Lot den Zwischenraum zwischen den Bauteilen vollständig ausfüllen kann. Durch das Löten entsteht eine dauerhafte und stabile Verbindung zwischen den Bauteilen. Außerdem weist das Lot bezüglich seiner Übertragungsparameter für den Ultraschall ähnliche Eigenschaften auf wie die des metallischen Materials des Verbindungselements.

Bei üblichen Lötprozessen muss das Verbindungselement für eine sichere Verbindung in Gänze vor dem eigentlichen Löten soweit erhitzt werden, dass die beim Lötvorgang eingebrachte Wärme ausreicht, das Lot zwischen dem Verbindungselement und dem piezoelektrischen Keramiksensor aufzuschmelzen.

Das komplette Erhitzen des Verbindungselements vor dem eigentlichen Lötvorgang ist jedoch sehr aufwendig und oftmals aufgrund der erforderlichen hohen Temperaturen nicht zulässig. Aus den genannten Gründen kann das herkömmliche Löten zum Aufbringen von piezoelektrischen Keramiksensoren auf Verbindungselemente in der Regel nicht verwendet werden.

Das vorgeschlagene Verfahren führt die für das Löten notwendige Wärme über eine zwischen den zu verbindenden Teilen des lastanzeigenden Bauelements angeordnete reaktive Schicht zu. Die beim Aktivieren dieser reaktiven Schicht kurzzeitig freiwerdende Energie ist ausreichend, um auch bei Verbindungselementen mit großer thermischer Masse, zum Beispiel Windkraftschrauben, lokal begrenzt solche Temperaturen zu erzeugen, dass eine sichere Verbindung zwischen Verbindungselement und piezoelektrischem Ultraschallwandler ermöglicht wird.

Da die Wärme schlagartig für einen kurzen Zeitraum frei wird, bleibt die Erwärmung vorteilhafterweise im Wesentlichen auf das reaktive System selbst, die angrenzende Lotschicht(en) und einen kleinen Bereich an der Oberfläche des Verbindungselements bzw. des Piezoelements begrenzt. Eine Beschädigung der zu verbindenden Bauteile wird dadurch vermieden, und dennoch wird eine sichere Lötverbindung ermöglicht.

### Kurze Beschreibung der Figuren

Ausführungsbeispiele der Erfindung sind in den Zeichnungen dargestellt und in der nachfolgenden Beschreibung näher erläutert. Es zeigen
Figur 1 das Verbinden eines Ultraschallwandlers mit einem Verbindungselement unter Verwendung eines reaktiven Schichtsystems vor einem Reagieren des reaktiven Schichtsystems,
Figur 2 das lastanzeigende Verbindungsbauteil mit dem verbundenen Ultraschallwandler,
Figur 3 eine schematische Ansicht einer Anpressvorrichtung für das Erzeugen eines definierten Anpressdrucks und
Figur 4 eine Vergleichsmessung zwischen einem erfindungsgemäßen lastanzeigenden Verbindungsbauteil und zwei Vergleichsbeispielen.

In der nachfolgenden Beschreibung der Ausführungsbeispiele der Erfindung werden gleiche Komponenten und Elemente mit gleichen Bezugszeichen bezeichnet, wobei auf eine wiederholte Beschreibung dieser Komponenten oder Elemente in Einzelfällen verzichtet wird. Die Figuren stellen den Gegenstand der Erfindung nur schematisch dar.

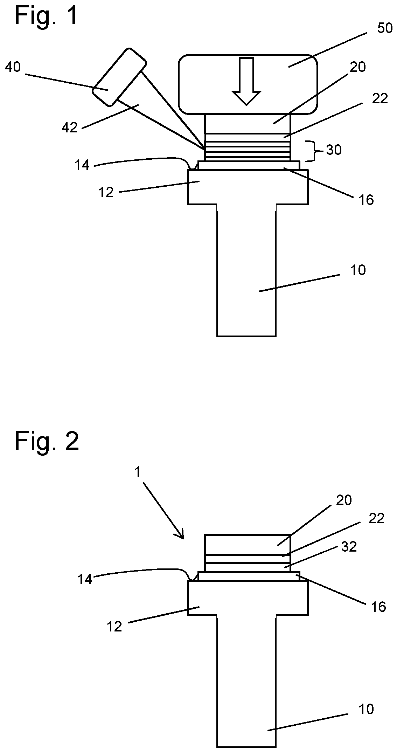

Figur 1 zeigt schematisch das Herstellen eines lastanzeigenden Verbindungsbauteils 1. Dabei werden ein Ultraschallwandler 20 und ein Verbindungselement 10 unter Verwendung eines reaktiven Schichtsystems 30 miteinander verbunden.

In der in Figur 1 dargestellten Situation ist das Verbindungselement 1 eine Schraube. Der Ultraschallwandler 20 soll im Bereich eines Schraubenkopfs 12 der Schraube mit der Oberfläche 14 des Verbindungselements 10 verbunden werden. Die Verbindung soll durch ein Lötverfahren hergestellt werden. Hierzu wurde die Oberfläche 14 mit einer ersten Lotschicht 16 versehen und eine Oberfläche des Ultraschallwandlers 20 wurde mit einer zweiten Lotschicht 22 versehen.

Beispielsweise lassen sich die Oberfläche 14 des Verbindungselements 10 und eine Oberfläche des Ultraschallwandlers 20 mittels dem PVD-Verfahren Sputtern auf einfache Weise mit einer Zinnbeschichtung als erste Lotschicht 16 und zweite Lotschicht 22 versehen.

Für das Herstellen einer stabilen Lötverbindung zwischen dem Verbindungselement 1 und dem Ultraschallwandler 20 müssen die beiden Lotschichten 16 und 22 zumindest an ihren Oberflächen aufgeschmolzen werden, so dass diese eine stoffschlüssige Verbindung eingehen können. Hierzu ist eine reaktive Schicht 30 vorgesehen, welche ein reaktives Schichtsystem aus alternierenden Schichten umfasst. Dabei sind beispielsweise Nickelschichten und Aluminiumschichten alternierend angeordnet. Das reaktive Schichtsystem ist derart eingerichtet, dass es nach einer Aktivierung, beispielsweise über eingebrachte Wärme, in einer exothermen Reaktion die für das Herstellen der Lotverbindung notwendige Wärmeenergie freisetzt.

Die reaktive Schicht 30 ist in dem auf der Oberfläche 14 des Verbindungselements 10 gebildeten Schichtsystem zwischen der ersten Lotschicht 16 und der zweiten Lotschicht 22 angeordnet. Die Fläche der reaktiven Schicht 30 ist in dem in Figur 1 dargestellten Beispiel so gewählt, dass diese der Fläche des Ultraschallwandlers 20 entspricht, so dass der Ultraschallwandler 20 die reaktive Schicht 30 vollständig abdeckt. Die Gesamtdicke der reaktiven Schicht 30 ist dabei so gewählt, dass durch Reaktion der reaktiven Schicht so viel Wärme freigesetzt wird, dass die erste und die zweite Lotschicht 16, 22 zumindest angeschmolzen werden und sich stoffschlüssig mit der reaktiven Schicht 30 verbinden. Die reaktive Schicht 30 setzt dabei nach einer Aktivierung die Wärme innerhalb kurzer Zeit frei, so dass der Ultraschallwandler 20 sowie das Verbindungselement 10 kaum erwärmt werden.

Für die Aktivierung der reaktiven Schicht 30 muss eine Aktivierungsenergie zugeführt werden. In dem in der Figur 1 skizzierten Beispiel wird dazu über einen Laser 40 ein Laserstrahl 42 von der Seite auf die reaktive Schicht 30 fokussiert und bringt auf diese Weise die notwendige Aktivierungsenergie am Rand der reaktiven Schicht 30 ein. Ist die reaktive Schicht 30 so zugeschnitten, dass deren Fläche größer ist als die des Ultraschallwandlers 20, so kann die Aktivierungsenergie auch an der Oberseite der reaktiven Schicht 30 eingebracht werden. Nach Aktivierung der reaktiven Schicht 30 erwärmt sich diese über eine exotherme Reaktion zwischen den enthaltenen alternierenden Schichten, wobei sich die Reaktion über das gesamte Volumen der reaktiven Schicht 30 ausbreitet und die reaktive Schicht 30 sowie zumindest Teile der angrenzenden Lotschichten 16, 22 aufschmilzt.

Damit die aufgeschmolzenen Schichten eine innige Verbindung eingehen und eventuell vorhandene Oberflächenunebenheiten durch das aufgeschmolzene Material aufgefüllt und ausgeglichen werden können, ist vorgesehen, während des Lotvorgangs den Ultraschallwandler 20 mit einem definierten Anpressdruck gegen das Verbindungselement 10 zu drücken. In dem in Figur 1 dargestellten Beispiel wird die zur Erzeugung des definierten Anpressdrucks notwendige Anpresskraft über einen Stempel 50 auf den Ultraschallwandler 20 übertragen.

Nach dem Erkalten ist die Lotverbindung zwischen dem Verbindungselement 10 und dem Ultraschallwandler 20 hergestellt und der Stempel 50 kann entfernt werden. Da die in der reaktiven Schicht 30 ablaufende Reaktion rasch abläuft, dauert das Verbinden in der Regel weniger als eine Sekunde.

Figur 2 zeigt ein gemäß dem in Figur 1 skizzierten Verfahren erhaltenes lastanzeigendes Verbindungsbauteil 1. Das Verbindungsbauteil 1 umfasst das Verbindungselement 10, welches in dem vorliegenden Beispiel als eine Schraube ausgestaltet ist, sowie den Ultraschallwandler 20, welche mit einer Lötverbindung stoffschlüssig verbunden sind. Zwischen der Oberfläche 14 des Verbindungselements 10 und der reagierten reaktiven Schicht 32 sind Teile der ersten Lotschicht 16 angeordnet, welche sich durch die Reaktionswärme der reaktiven Schicht 30 mit der Oberfläche 14 des Verbindungselements 10 verbunden hat und teilweise mit der reagierten reaktiven Schicht 32 verschmolzen ist. Teile der zweiten Lotschicht 22 befinden sich zwischen der reagierten reaktiven Schicht 32 und dem Ultraschallwandler 22, wobei Teile der zweiten Lotschicht 22 mit der reagierten reaktiven Schicht 32 verschmolzen sind.

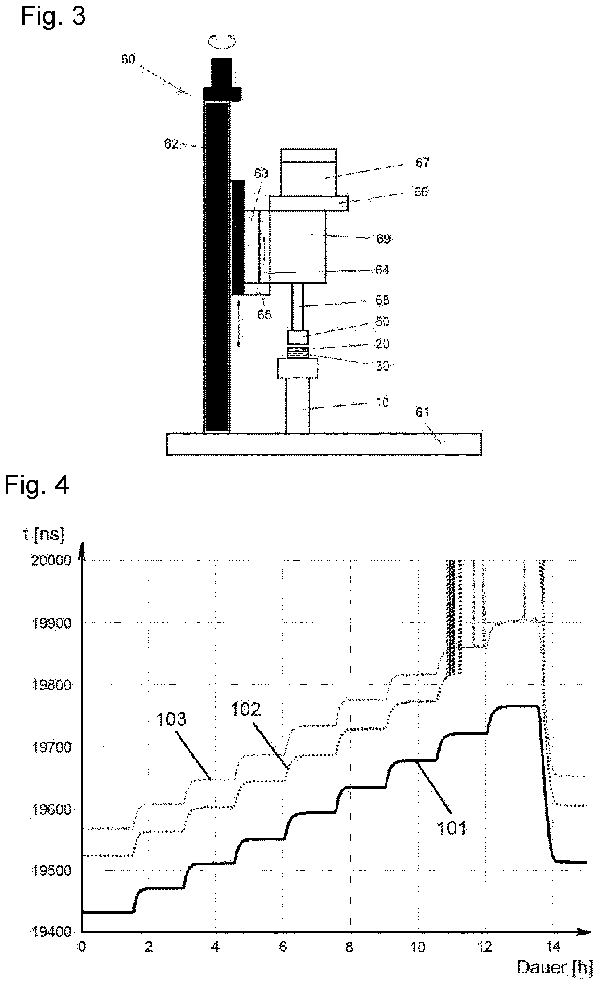

Figur 3 zeigt eine schematische Ansicht einer Anpressvorrichtung 60 für das Erzeugen eines definierten Anpressdrucks zum Pressen des Ultraschallwandlers 20 gegen das Verbindungselement 10 während des Lotvorgangs.

Die Anpressvorrichtung 60 umfasst einen Sockel 61, auf den das Verbindungselement 10 zusammen mit dem auf dessen Oberfläche 14 gebildeten Schichtsystem umfassend die reaktive Schicht 30 und den Ultraschallwandler 20 platziert wird. Die Anpressvorrichtung 60 umfasst ferner eine Lineareinheit 62 zur Höhenverstellung. An der Lineareinheit 62 sind eine Linearführung 63 mit einem beweglichen Schlitten 64 und ein Anschlag 65 montiert. Am Schlitten 64 der Linearführung ist eine Federpinaufnahme 69 mit einer Plattform 66 befestigt. Der bewegliche Schlitten 64 liegt zunächst auf dem Anschlag 65 auf.

Die Plattform 66 dient als Ablage für bewegliche Gewichte 67. In dem Beispiel der Figur 3 ist ein einziges Gewicht 67 dargestellt, es können aber auch mehrere Gewichte 67 verwendet werden, um die gewünschte Anpresskraft vorzugeben. Die Federpinaufnahme 69 fungiert als Halterung für einen Federpin 68, der die Aufgabe erfüllt, die Anpresskraft als definierten Anpressdruck auf den Ultraschallwandler 20 zu übertragen. Hierzu wird der Federpin 68 mit einer Feder in eine vollständig ausgefahrene Position vorgespannt. Für die Übertragung des Anpressdrucks weist der Federpin 68 an seinem dem Ultraschallwandler 20 zugewandten Ende einen Stempel 50 auf, der als Kontaktfläche dient.

Nach Platzieren des Verbindungselements 10 zusammen mit dem Schichtsystem, welches zumindest die reaktive Schicht 30 und den Ultraschallwandler 20 umfasst, wird der Anschlag 65 unter Verwendung der Lineareinheit 62 abgesenkt, wobei die mit dem in der Linearführung 63 aufgenommenen beweglichen Schlitten 64 verbundenen Komponenten, nämlich der Federpin 68, die Federpinaufnahme 69, die Plattform 66, die Gewichte 67 dem Anschlag 65 folgend ebenfalls abgesenkt werden.

Bei dem Absenken wird der Ultraschallwandler 20 über den Stempel 50 des Federpins 68 kontaktiert. Während des weiteren Absenkens steigt die auf den Ultraschallwandler 20 ausgeübte Kraft, während der Federpin 68 zunehmend eingefahren wird. Beispielsweise kann eine Federwirkung des Federpins 68 so gewählt werden, dass eine Anpresskraft im Bereich von 1 bis 3 N bis zum vollständigen Einfahren des Federpins 68 erreicht wird.

Nach dem vollständigen Einfahren des Federpins 68 liegt die Federpinaufnahme 69 nicht länger auf dem Anschlag 65 auf und bewegt sich in seiner Linearführung 63 relativ zum Anschlag 65 bei weiterem Absenken des Anschlags 65 mit der Lineareinheit 62. Dadurch wird die volle Gewichtskraft des Gewichts 67, der Plattform 66, der Federpinaufnahme 69 und des Federpins 68 auf den Ultraschallwandler 20 übertragen.

Die Anpresskraft wird entsprechend durch die Wahl der Masse der Gewichte 67 vorgegeben. Die Anpresskraft wird über die Kontaktfläche des Federpins 68 auf den Ultraschallwandler übertragen, wobei sich der Anpressdruck über die Gewichtskraft und die Fläche des Ultraschallwandlers 20 definiert.

Die Größe des Stempels 50 des Federpins 68 ist so zu wählen, dass dessen Kontaktfläche möglichst der zum Federpin 68 weisenden Fläche des Ultraschallwandlers 20 entspricht. Die Anpressvorrichtung 60 ist so gestaltet, dass sich Federpinaufnahme 69 und Federpin 68 leicht wechseln lassen, um eine schnelle Anpassung an sich wechselnde Ultraschallwandlergrößen zu gewährleisten.

Figur 4 zeigt eine Vergleichsmessung der Ultraschalllaufzeiten für ein erfindungsgemäßes lastanzeigendes Verbindungsbauteil, bei dem der Ultraschallwandler mit dem Verbindungselement verlötet ist, im Vergleich zu zwei lastanzeigenden Verbindungsbauteilen als Vergleichsbeispiele, bei denen der Ultraschallwandler gemäß dem Stand der Technik aufgeklebt wurde. Das Diagramm der Figur 4 stellt dabei die gemessene Schalllaufzeit t für eine time-of-flight Messung in Abhängigkeit von der Temperatur T des jeweiligen Verbindungsbauteils dar.

Bei einer time-of-flight Messung wird unter Verwendung des Ultraschallwandlers ein Ultraschallsignal in Form eines zeitlich begrenzten Pulses ausgesendet. Der Ultraschallpuls durchläuft das Verbindungselement und wird an einem Ende des Verbindungselements reflektiert. Das reflektierte Ultraschallsignal wird dann als Ultraschallecho wieder gemessen. Die Schalllaufzeit t ist dabei die Zeitspanne, die seit dem Aussenden des Ultraschallpulses bis zum Empfang des Ultraschallechos vergangen ist.

Die verwendeten lastanzeigenden Verbindungsbauteile weisen jeweils identische M12x50 Schrauben aus Stahl als Verbindungselement auf. Auf dem Schraubenkopf der M12x50 Schrauben sind jeweils Ultraschallwandler aufgebracht.

Als Ultraschallwandler wurde eine Piezokeramik mit einem Durchmesser von 5mm und einer Dicke von 0,5 mm verwendet.

Bei dem erfindungsgemäßen lastanzeigenden Verbindungsbauteil wurde der Ultraschallwandler unter Verwendung einer Bondfolie mit der Schraube verlötet. Hierzu wurden sowohl der Schraubenkopf als auch die Piezokeramik mit Lotschichten aus Zinn versehen. Dazu wurden 30 µm dicke Zinnschichten mit einem Sputterverfahren auf den Oberflächen abgeschieden.

Für das Verbinden des Ultraschallwandlers mit der Schraube wurde eine 40 µm dicke Al/Ni Bondfolie NanoFoil^{®} von der Firma Indium Corporation verwendet, welche mit Kurzpulslaserschneiden auf den Durchmesser des Ultraschallwandlers zugeschnitten wurde.

Bei den beiden Vergleichsbeispielen wurden die Ultraschallwandler auf die Schrauben aufgeklebt. Für das erste Vergleichsbeispiel wurde ein anaerober Acrylatkleber verwendet, für das zweite Vergleichsbeispiel ein Epoxidkleber.

Abbildung 4 zeigt die gemessenen Laufzeiten in Abhängigkeit von der Temperatur für die drei M12x50-Schrauben. Eine erste Kurve 101 zeigt die gemessenen Schalllaufzeiten für das erfindungsgemäße lastanzeigende Verbindungsbauteil. Eine zweite Kurve 102 zeigt die Messungen der Schallaufzeiten für das erste Vergleichsbeispiel und eine dritte Kurve 103 zeigt die Messungen der Schalllaufzeiten für das zweite Vergleichsbeispiel. Für alle drei Kurven 101, 102, 103 ist zu erkennen, dass bei zunehmender Temperatur die gemessene Schalllaufzeit ansteigt.

Beginnend bei -20 °C erhöhen sich die Laufzeiten der Schrauben schrittweise mit jeder Temperaturstufe. Die Anhebung der Temperatur erfolgt in 20 K-Schritten. Bis zur Temperaturstufe von 100 °C verlaufen die Kurven 101, 102, 103 analog. Für die Temperaturstufen 120 °C und 140 °C zeigen beide geklebten Ultraschallwandler gemäß den Vergleichsbeispielen Ausfallerscheinungen, erkennbar an den sprunghaften Ausschlägen nach oben. Diese werden hervorgerufen durch den zeitweisen Kontaktverlust der Elektrode der dem Schraubenkopf zugewandten Seite der Ultraschallwandler. Erkennen die Anwender oder automatisierte Messsysteme diese Probleme nicht, sind Fehlmessungen die Folge. Ebenso problematisch, weil nicht immer sofort erkennbar, sind Veränderungen in der Echostruktur der Ultraschallsignale, die durch thermische oder Einflüsse der Umwelt auf die Klebeschicht und deren Alterung hervorgerufen werden. Auch diese Probleme führen zu verfälschten Messergebnissen. Durch den Einsatz von mittels Bondfolie aufgebrachter Ultraschallwandler lassen sich die genannten Probleme eliminieren.

Im Vergleich ist somit aus den in Figur 4 dargestellten Messungen klar erkennbar, dass bei dem erfindungsgemäßen Ausführungsbeispiel mit verlötetem Ultraschallwandler die Ultraschalllaufzeit auch bei höheren Temperaturen oberhalb von 100°C sicher gemessen werden kann.

### Bezugszeichenliste

- 1: lastanzeigendes Verbindungsbauteil
- 10: Verbindungselement
- 12: Schraubenkopf
- 14: Oberfläche
- 16: erste Lotschicht

- 20: Ultraschallwandler
- 22: zweite Lotschicht

- 30: reaktive Schicht
- 32: reagierte reaktive Schicht

- 40: Laser
- 42: Laserstrahl

- 50: Stempel

- 60: Anpressvorrichtung
- 61: Sockel
- 62: Lineareinheit zur Höhenverstellung
- 63: Linearführung
- 64: beweglicher Schlitten der Linearführung
- 65: Anschlag
- 66: Plattform
- 67: Gewichte
- 68: Federpin
- 69: Federpinaufnahme

- 101: erste Kurve
- 102: zweite Kurve
- 103: dritte Kurve

## Patentansprüche

1. Verfahren zur Herstellung von lastanzeigenden Verbindungsbauteilen (1), wobei
- ein Verbindungselement (10) sowie ein piezoelektrischer Ultraschallwandler (20) bereitgestellt und miteinander verbunden werden,
- das Verbindungselement (10) eine Schraube ist und die Oberfläche (14) der Schraube (10) eine Oberfläche des Schraubenkopfs der Schraube oder eine Oberfläche an dem dem Schraubenkopf entgegengesetzten Ende der Schraube ist,
- die Schraube (10) aus der Gruppe der nachstehend aufgeführten Materialien gefertigt ist: Stahl, Edelstahl, hochlegierte Stähle, Sonderstähle, Titan und dessen Legierungen, TiAl6V4, Aluminium und dessen Legierungen, Nickellegierungen (Inconel), amagnetische Stähle, wie A286, Messing oder Kupfer und dessen Legierungen
**gekennzeichnet durch** folgende Schritte:
a) Bilden einer Schichtstruktur auf der Oberfläche (14) der Schraube (10), welche in dieser Reihenfolge ausgehend von der Oberfläche (14) der Schraube (10) eine erste Lotschicht (16), eine reaktive Schicht (30), eine zweite Lotschicht (22), und den Ultraschallwandler (20) umfasst, wobei die reaktive Schicht (30) eine Dicke im Bereich von 10 µm bis 100 µm aufweist und für eine exotherme Reaktion durch Aktivieren mit Wärme, elektromagnetischer Strahlung oder elektrischem Strom eingerichtet ist,
b) Pressen des Ultraschallwandlers (20) in Richtung der Schraube (10) mit einem vorgegebenen Anpressdruck, und
c) Aktivieren der reaktiven Schicht (30).

2. Verfahren nach Anspruch 1, **dadurch gekennzeichnet, dass** der Schritt a) folgende Schritte umfasst: Zuschneiden einer reaktiven Bondfolie, welche die reaktive Schicht (30) aufweist, Auflegen der reaktiven Bondfolie auf die erste Lotschicht (16) auf der Schraube (10) und Auflegen des piezoelektrischen Ultraschallwandlers (20) auf die Bondfolie, wobei die sich auf dem Ultraschallwandler (20) befindliche zweite Lotschicht (22) in Richtung der reaktiven Bondfolie weist.

3. Verfahren nach Anspruch 2, **dadurch gekennzeichnet, dass** die Bondfolie derart zugeschnitten wird, dass die Form der Bondfolie der Form des Ultraschallwandlers (20) entspricht.

4. Verfahren nach Anspruch 2, **dadurch gekennzeichnet, dass** die Bondfolie derart zugeschnitten wird, dass ein Teil der Bondfolie nach dem Auflegen des Ultraschallwandlers (20) nicht durch den Ultraschallwandler (20) überdeckt ist.

5. Verfahren nach einem der Ansprüche 2 bis 4, **dadurch gekennzeichnet, dass** das Zuschneiden der Bondfolie mittels Laserschneiden erfolgt.

6. Verfahren nach einem der Ansprüche 1 bis 5, **dadurch gekennzeichnet, dass** als die erste Lotschicht (16) und als die zweite Lotschicht (22) eine Lotschicht eingesetzt wird, die aus einem Schichtsystem besteht, welches mindestens eine haftverbessernde Zwischenschicht und eine Hauptschicht mit einem Lotmaterial enthält.

7. Verfahren nach einem der Ansprüche 1 bis 6, **dadurch gekennzeichnet, dass** im Verfahren der vorgegebene Anpressdruck im Bereich von 0,3 MPa bis 3 MPa vorgegeben ist.

8. Verfahren nach einem der Ansprüche 1 bis 7, **dadurch gekennzeichnet, dass** als reaktive Schicht (30) eine reaktive Schicht eingesetzt wird, die ein System alternierender Schichten umfasst, wobei die alternierenden Schichten ausgewählt sind aus Ni/Al, Al/Pd, Al/Ti oder Ti/Ni.

9. Verfahren nach einem der Ansprüche 1 bis 8, **dadurch gekennzeichnet, dass** die Oberfläche (14) der Schraube (10) verzinkt ist.

10. Lastanzeigendes Verbindungsbauteil (1) erhalten durch ein Verfahren nach einem der Ansprüche 1 bis 9, wobei das lastanzeigende Verbindungsbauteil (1) eine Schraube (10) aufweist,
**gekennzeichnet durch**
eine auf der Oberfläche (14) der Schraube (10) angeordneten Schichtstruktur, wobei die Schichtstruktur ausgehend von der Oberfläche (14) der Schraube (10) eine erste Lotschicht (16),
eine reagierte reaktive Schicht (32),
eine zweite Lotschicht (22),
und einen Ultraschallwandler (22) in dieser Reihenfolge aufweist, wobei die reagierte reaktive Schicht (32) Teile der ersten Lotschicht (16) und Teile der zweiten Lotschicht enthält, wobei die Oberfläche (14) der Schraube (10) eine Oberfläche des Schraubenkopfs der Schraube (10) oder eine Oberfläche an dem Schraubenkopf entgegengesetzten Ende der Schraube (10) ist, und wobei die Schraube (10) aus der Gruppe der nachstehend aufgeführten Materialien gefertigt ist: Stahl, Edelstahl, hochlegierte Stähle, Sonderstähle, Titan und dessen Legierungen, TiAl6V4, Aluminium und dessen Legierungen, Nickellegierungen (Inconel), amagnetische Stähle, wie A286, Messing oder Kupfer und dessen Legierungen.

## Claims

1. A method for producing load-indicating connection components (1), wherein
- a connection element (10) and a piezoelectric ultrasonic transducer (20) are provided and interconnected,
- the connection element (10) is a screw and the surface (14) of the screw (10) is a surface of the screw head of the screw or a surface at the end of the screw opposite to the screw head,
- the screw (10) is fabricated from the group of materials listed below: steel, stainless steel, high-alloy steels, special steels, titanium and its alloys, TiAl6V4, aluminum and its alloys, nickel alloys (Inconel), amagnetic steels such as A286, brass or Copper and its alloys
**characterized by** the following steps:
a) forming a layer structure on the surface (14) of the screw (10), which in this order proceeding from the surface (14) of the screw (10) comprises a first solder layer (16), a reactive layer (30), a second solder layer (22) and the ultrasonic transducer (20), wherein the reactive layer (30) has a thickness in the range from 10 µm to 100 µm and is adapted for an exothermic reaction by activation with heat, electromagnetic radiation or electric current,
b) pressing the ultrasonic transducer (20) toward the screw (10) with a specified contact pressure, and
c) activating the reactive layer (30).

2. Method according to claim 1, **characterized in that** step a) comprises the following steps: cutting to size a reactive bonding foil that comprises the reactive layer (30), placing the reactive bonding foil onto the first solder layer (16) on the screw (10), and placing the piezoelectric ultrasonic transducer (20) onto the bonding foil, wherein the second solder layer (22) located on the ultrasonic transducer (20) points toward the reactive bonding foil.

3. Method according to claim 2, **characterized in that** the bonding foil is cut to size such a way that the shape of the bonding foil corresponds to the shape of the ultrasonic transducer (20).

4. Method according to claim 2, **characterized in that** the bonding foil is cut to size in such a way that a part of the bonding foil is not covered by the ultrasonic transducer (20) after placing the ultrasonic transducer (20) onto the same.

5. Method according to anyone of claims 2 to 4, **characterized in that** the cutting to size of the bonding foil is effected by means of laser cutting.

6. Method according to anyone of claims 1 to 5, **characterized in that** as the first solder layer (16) and as the second solder layer (22) there is used a solder layer that consists of a layer system which contains at least one adhesion-improving intermediate layer and a main layer comprising a solder material.

7. Method according to anyone of claims 1 to 6, **characterized in that** in the method the specified contact pressure is specified in the range from 0.3 MPa to 3 MPa.

8. Method according to anyone of claims 1 to 7, **characterized in that** as the reactive layer (30) there is used a reactive layer which comprises a system of alternating layers, wherein the alternating layers are selected from Ni/Al, Al/Pd, Al/Ti or Ti/Ni.

9. Method according to anyone of claims 1 to 8, **characterized in that** the surface (14) of the screw (10) is zinc-plated.

10. Load-indicating connection component (1) obtained by a method according to anyone of claims 1 to 9, wherein the load-indicating connection component (1) comprises a screw (10),
**characterized by**
a layer structure arranged on the surface (14) of the screw (10), wherein the layer structure in this order proceeding from the surface (14) of the screw (10) comprises
a first solder layer (16),
a reacted reactive layer (32),
a second solder layer (22),
and an ultrasonic transducer (22) in this order, the reacted reactive layer (32) containing parts of the first solder layer (16) and parts of the second solder layer, the surface (14) of the screw (10) being a surface of the screw head of the screw (10) or a surface at the end of the screw (10) opposite the screw head, and wherein the screw (10) is fabricated from the group of materials listed below: steel, stainless steel, high-alloy steels, special steels, titanium and its alloys, TiAl6V4, aluminum and its alloys, nickel alloys (Inconel), amagnetic steels such as A286, brass or copper and their alloys.

## Revendications

1. Procédé de fabrication de composants de liaison (1) indicateurs de charge, dans lequel
- un élément de liaison (10) et un transducteur ultrasonore piézoélectrique (20) sont fournis et reliés entre eux,
- l'élément de liaison (10) est une vis, et la surface (14) de la vis (10) est une surface de la tête de la vis ou une surface à l'extrémité de la vis opposée à la tête de la vis,
- la vis (10) est réalisée à partir d'un matériau parmi le groupe de matériaux suivants : acier, acier inoxydable, aciers fortement alliés, aciers spéciaux, titane et ses alliages, TiAl6V4, aluminium et ses alliages, alliages de nickel (Inconel), aciers amagnétiques tels que A286, laiton ou cuivre et ses alliages,
**caractérisé par** les étapes suivantes consistant à :
a) former une structure stratifiée sur la surface (14) de la vis (10) qui, partant de la surface (14) de la vis (10), présente dans cet ordre
une première couche d'apport de brasage (16),
une couche réactive (30),
une deuxième couche d'apport de brasage (22), et
le transducteur ultrasonore (20),
la couche réactive (30) ayant une épaisseur dans la plage de 10 µm à 100 µm et étant conçue pour une réaction exothermique par activation avec de la chaleur, un rayonnement électromagnétique ou un courant électrique,
b) presser le transducteur ultrasonore (20) en direction de la vis (10) avec une pression de pressage prédéterminée, et
c) activer la couche réactive (30).

2. Procédé selon la revendication 1,
**caractérisé en ce que** l'étape a) comprend les étapes suivantes consistant à :
découper un film d'interconnexion réactif qui présente la couche réactive (30),
poser le film d'interconnexion réactif sur la première couche d'apport de brasage (16) sur la vis (10), et
poser le transducteur ultrasonore piézoélectrique (20) sur le film d'interconnexion, la deuxième couche d'apport de brasage (22) située sur le transducteur ultrasonore (20) étant orientée vers le film d'interconnexion réactif.

3. Procédé selon la revendication 2,
**caractérisé en ce que** le film d'interconnexion est découpé de manière à ce que la forme du film d'interconnexion corresponde à la forme du transducteur ultrasonore (20).

4. Procédé selon la revendication 2,
**caractérisé en ce que** le film d'interconnexion est découpé de manière à ce qu'une partie du film d'interconnexion ne soit pas recouverte par le transducteur ultrasonore (20), après la mise en place du transducteur ultrasonore (20).

5. Procédé selon l'une des revendications 2 à 4,
**caractérisé en ce que** la découpe du film d'interconnexion est réalisée par découpe au laser.

6. Procédé selon l'une des revendications 1 à 5,
**caractérisé en ce qu'**on utilise comme première couche d'apport de brasage (16) et comme deuxième couche d'apport de brasage (22) une couche d'apport de brasage qui est constituée d'un système de couches qui comprend au moins une couche intermédiaire améliorant l'adhérence et une couche principale avec un matériau d'apport de brasage.

7. Procédé selon l'une des revendications 1 à 6,
**caractérisé en ce que** dans le procédé, la pression de pressage prédéterminée est définie dans la plage de 0,3 MPa à 3 MPa.

8. Procédé selon l'une des revendications 1 à 7,
**caractérisé en ce que** l'on utilise comme couche réactive (30) une couche réactive qui comprend un système de couches alternées, les couches alternées étant choisies parmi Ni/Al, Al/Pd, Al/Ti ou Ti/Ni.

9. Procédé selon l'une des revendications 1 à 8,
**caractérisé en ce que** la surface (14) de la vis (10) est galvanisée.

10. Composant de liaison (1) indicateur de charge, obtenu par un procédé selon l'une des revendications 1 à 9,
dans lequel le composant de liaison (1) indicateur de charge comprend une vis (10),
**caractérisé par**
une structure stratifiée disposée sur la surface (14) de la vis (10),
la structure stratifiée présentant, à partir de la surface (14) de la vis (10), dans cet ordre
une première couche d'apport de brasage (16),
une couche réactive (30) ayant réagi,
une deuxième couche d'apport de brasage (22), et
un transducteur ultrasonore (20),
la couche réactive (30) ayant réagi comprenant des parties de la première couche d'apport de brasage (16) et des parties de la deuxième couche d'apport de brasage, la surface (14) de la vis (10) étant une surface de la tête de la vis (10) ou une surface de l'extrémité de la vis (10) opposée à la tête de la vis, et la vis (10) étant réalisée à partir d'un matériau parmi le groupe de matériaux suivants : acier, acier inoxydable, aciers fortement alliés, aciers spéciaux, titane et ses alliages, TiAl6V4, aluminium et ses alliages, alliages de nickel (Inconel), aciers amagnétiques tels que A286, laiton ou cuivre et ses alliages.
